# DEMANDE DE BREVET EUROPEEN

(11) **EP 4 741 855 A1**
(43) Date de publication de la demande: **13.05.2026**
(21) Numéro de dépôt: 25213843.3
(22) Date de dépôt: 06.11.2025
(51) Int. Cl.: G01R 31/392

(54) **PROCÉDÉ ET SYSTÈME DE DÉTERMINATION D'UN ÉTAT DE SANTÉ FINAL D'UNE BATTERIE D'UN VÉHICULE AUTOMOBILE ÉLECTRIQUE OU HYBRIDE**

(30) Priorité: 07.11.2024 FR 2412208
(71) Demandeur: AMPERE s.a.s., 92100 Boulougne-Billancourt (FR)
(72) Inventeur: NGUYEN, Olivier, 78084 Guyancourt (FR); HADJ-HAMOU, Rayan, 78084 Guyancourt (FR)
(74) Mandataire: Renault Group

(57) **Abrégé**

- Procédé et système de détermination d'un état de santé final d'une batterie d'un véhicule automobile électrique ou hybride.
- Le système de détermination (1) comprend une unité de réception (4) configurée pour recevoir une énergie déchargée (X₁) pendant un premier cyclage et d'une i-ème énergie déchargée (Xi) pendant un i-ème cyclage, une unité de calcul (6) configurée pour déterminer un état de santé final (SoH_{1b}) à la fin du premier cyclage et pour déterminer l'état de santé final (SoH_{1N}) en posant que le i-ème état de santé initial (SoHᵢₐ) est égal au (i-1)-ème état de santé final (SoH_{(i-1)b}) à la fin du (i-1)-ème cyclage et une unité de transmission (7) configurée pour transmettre l'état de santé final (SoH_{1N}) de la batterie (2) à un dispositif utilisateur (8).

## Description

### Domaine technique

La présente invention concerne un procédé et un système de détermination d'un état de santé final d'une batterie d'un véhicule automobile électrique ou hybride soumis à une pluralité de cycles d'utilisation successifs, deux cycles consécutifs présentant des profils de dégradation distincts l'un de l'autre.

### État de la technique

Au cours de son utilisation, une batterie (de traction) d'un véhicule automobile à motorisation électrique ou hybride est amenée à vieillir. La batterie peut en effet être soumise à au moins un cycle d'utilisation, dit aussi cyclage. Un cyclage correspond à une utilisation particulière de la batterie en charge et en décharge.

L'état de santé (SoH pour « state of health » en anglais) d'une batterie est généralement défini à un instant t comme étant le rapport entre, d'une part, l'énergie ou la capacité totale qu'il est possible d'extraire de la batterie à cet instant t et, d'autre part, l'énergie ou la capacité totale qu'il est possible d'extraire de la batterie avant toute utilisation de celle-ci, c'est-à-dire lorsque la batterie est neuve. L'état de santé d'une batterie, souvent exprimé en pourcentage, présente donc un indicateur qui rend compte d'un pourcentage d'énergie résiduelle d'une batterie, une partie de l'énergie étant perdure irréversiblement du fait de l'utilisation et de la dégradation associées de la batterie.

La connaissance de l'état de santé et du vieillissement de la batterie est un enjeu important pour les constructeurs automobiles et fabricants de batteries du point de vue technique. En effet, la connaissance du SoH permet de connaître le temps de vie d'une batterie. Par exemple, quand le SoH indique que la batterie est en fin de vie, il sera peut-être nécessaire de changer la batterie. Cette connaissance de l'état de santé est également un enjeu important du point de vue économique. En effet, maximiser le SoH permet, par exemple, d'envisager une seconde vie pour la batterie. Cette connaissance est également un enjeu important du point de vue réglementaire. En effet, la réglementation définit la précision du SoH.

Il existe déjà plusieurs procédés pour déterminer le SoH d'une batterie.

Le SoH peut être déterminé par mesure directe, soit hors véhicule (batterie extraite du véhicule), soit pendant son utilisation nécessitant une phase dédiée d'utilisation du véhicule.

Le SoH peut également être déterminé par prédiction à l'aide de modèles semi-empiriques. Cette méthode par prédiction est à même d'estimer le SoH du véhicule à tout instant et d'en informer le client en temps réel.

Toutefois, actuellement, face à la multiplication des usages clients, on assiste à une diversification des types de sollicitation en cyclage de la batterie. En effet, au roulage classique associé à une charge traditionnelle faite sur borne de puissance généralement limitée à des faibles puissances (entre 7 kW et 11 kW par exemple), s'ajoutent aujourd'hui des utilisations avec charges rapides (avec des puissances supérieures à 100 kW), ou de nouveaux usages tels le « Vehicle-to-Grid » (V2G) ou le « Vehicle-to-Load » (V2L), dans lesquels la batterie est utilisée pour alimenter un réseau électrique ou un appareil électrique. Cette diversité des usages peut se traduire par des profils de dégradation différents, c'est-à-dire à des cinétiques ou en d'autres termes à des vitesses de dégradation elles-mêmes variées selon le type de cyclage.

Ainsi, d'une situation historiquement simple dans laquelle un seul type de cyclage est réalisé, on est passé à une situation plus complexe dans laquelle plusieurs types de cyclage et usages très différents sont réalisés. On peut distinguer notamment un profil de cyclage spécifique au roulage du véhicule (c'est-à-dire : à vitesse non nulle) ; un profil lié à une charge lente du véhicule ; un profil lié à une charge rapide du véhicule ; un profil lié à une utilisation de la batterie pour recharger un réseau électrique extérieur au véhicule, de type dit V2G ; etc.

Il existe toutefois des procédés permettant de déterminer le SoH en tenant compte du nombre d'utilisations ou cyclages différents.

Un procédé est fondé sur un modèle se basant sur une loi unique de dégradation. Autrement dit, si la batterie est soumise à au moins deux types de cyclage dont les lois de cinétique de dégradation diffèrent, alors une loi de cinétique de vieillissement « moyennée » est déterminée afin de considérer une loi unique de dégradation en cyclage. Or, il peut se révéler factuellement difficile de trouver une loi de cinétique moyennée, soit parce qu'analytiquement il est difficile de la construire, soit parce qu'il faudrait multiplier les tests coûteux et chronophages pour y parvenir.

Un autre procédé revient à sommer des dégradations en cyclage de manière indépendantes. Autrement dit, tout se passe comme si les dégradations du SoH d'une batterie soumise tantôt à un cyclage A et tantôt à cyclage B étaient égales aux dégradations du SoH calculées indépendamment selon le cyclage A d'une part et le cyclage B d'autre part selon une « loi d'additivité » de la dégradation du SoH. Or, on sait que cette loi n'est mathématiquement pas correcte et qu'on se heurte en l'utilisant à des imprécisions d'estimation du SoH. De plus, ce procédé ne tient pas compte du vieillissement de la batterie. En effet, à chaque cyclage, on détermine la dégradation du SoH en prenant comme point de départ le SoH d'une batterie neuve sans prendre en compte le vieillissement de la batterie pour le ou les cyclages précédents.

Les procédés de détermination du SoH des batteries ne sont donc pas pleinement satisfaisantes.

### Exposé de l'invention

La présente invention a pour objet de proposer un procédé de détermination d'un état de santé d'une batterie d'un véhicule automobile électrique ou hybride qui tient compte du vieillissement de la batterie.

Pour cela, elle concerne un procédé de détermination d'un état de santé final d'une batterie d'un véhicule automobile électrique ou hybride susceptible d'être soumise à N cyclages successifs, N étant au moins égal à deux, chaque cyclage étant associé à une courbe de dégradation indiquant l'état de santé de la batterie en fonction d'une énergie déchargée par la batterie, les courbes de dégradation de deux cyclages consécutifs étant distinctes l'une de l'autre.

Selon l'invention, le procédé de détermination comprend les étapes suivantes :
- une première étape de réception, mise en œuvre par une unité de réception, pour recevoir d'un compteur d'énergie un signal représentatif d'une première énergie déchargée pendant le premier cyclage ;
- une première étape de détermination, mise en œuvre par une unité de calcul, pour déterminer un premier état de santé final à la fin d'un premier cyclage à partir d'une première courbe de dégradation associée au premier cyclage et de la première énergie déchargée pendant le premier cyclage ;
- la suite d'étapes suivantes répétée de i = 2 à i = N :
   ∘ une i-ème étape de réception, mise en œuvre par l'unité de réception, pour recevoir du compteur d'énergie un signal représentatif d'une i-ème énergie déchargée pendant le i-ème cyclage,
   ∘ une i-ème étape de détermination, mise en œuvre par l'unité de calcul, pour déterminer l'état de santé final, un i-ème état de santé final à la fin du i-ème cyclage étant déterminé à partir d'une i-ème courbe de dégradation associée au i-ème cyclage et en posant que le i-ème état de santé initial est égal au (i-1)-ème état de santé final à la fin du (i-1)-ème cyclage ;
- une étape de transmission, mise en œuvre par une unité de transmission, pour transmettre un signal représentatif de l'état de santé final de la batterie à un dispositif utilisateur.

Ainsi, grâce au procédé dans lequel le i-ème état de santé initial est égal au (i-1)-ème état de santé final à la fin du (i-1)-ème cyclage, le SoH peut être déterminer de façon beaucoup plus précise.

Avantageusement, la première étape de réception E1 est mise en œuvre par l'unité de réception 4 pour recevoir en outre du système de gestion de batterie BMS un signal de début et un signal de fin de fonctionnement de la batterie selon un cyclage particulier correspondant à une courbe de dégradation spécifique au premier cyclage C₁.

De même, pour i = 2 à i = N, la i-ème étape de réception E1ᵢ est mise en œuvre par l'unité de réception 4 pour recevoir en outre du système de gestion de batterie BMS un signal de début puis un signal de fin de fonctionnement de la batterie selon un cyclage particulier correspondant à une courbe de dégradation spécifique au i-ème cyclage Cᵢ.

Avantageusement, la i-ème étape de détermination comprend :
- une sous-étape de détermination d'une i-ème énergie initiale au début du i-ème cyclage à partir d'un i-ème état de santé initial et d'une i-ème courbe de dégradation, le i-ème état de santé initial étant égal au (i-1)-ème état de santé final à la fin du (i-1)-ème cyclage,
- une sous-étape de détermination d'un i-ème état de santé final à la fin du i-ème cyclage à partir de la i-ème courbe de dégradation associée au i-ème cyclage et d'une somme de la i-ème énergie initiale et d'une i-ème énergie déchargée pendant le i-ème cyclage,
- une sous-étape de détermination d'un état de santé de la batterie, l'état de santé de la batterie étant égale à la différence entre le i-ème état de santé initial et le i-ème état de santé final.

De plus, le premier cyclage présente un état de santé initial correspondant à un état de santé d'une batterie neuve.

Par ailleurs, la première étape de réception est mise en œuvre par l'unité de réception en outre pour recevoir des premières données de fonctionnement caractéristiques du premier cyclage, la première courbe de dégradation étant choisie par l'unité de calcul en fonction des données de fonctionnement ;
la i-ème étape de réception étant mise en œuvre par l'unité de réception en outre pour recevoir des i-èmes données de fonctionnement, la i-ème courbe de dégradation étant choisie par l'unité de calcul en fonction des i-èmes données de fonctionnement.

L'invention concerne également un système de détermination d'un état de santé final d'une batterie d'un véhicule automobile électrique ou hybride susceptible d'être soumise à N cyclages successifs, N étant au moins égal à deux, chaque cyclage étant associé à une courbe de dégradation indiquant l'état de santé de la batterie en fonction d'une énergie déchargée par la batterie, les courbes de dégradation de deux cyclages consécutifs étant distinctes l'une de l'autre.

Selon l'invention, le système de détermination comprend :
- une unité de réception configurée pour recevoir d'un compteur d'énergie un signal représentatif d'une première énergie déchargée pendant le premier cyclage,
- une unité de calcul configurée pour déterminer un premier état de santé final à la fin d'un premier cyclage à partir d'une première courbe de dégradation associée au premier cyclage et de la première énergie déchargée pendant le premier cyclage ;
pour i = 2 à i = N :
- l'unité de réception étant configurée pour recevoir du compteur d'énergie un signal représentatif d'une i-ème énergie déchargée pendant le i-ème cyclage,
- l'unité de calcul étant configurée pour déterminer l'état de santé final, un i-ème état de santé final à la fin du i-ème cyclage étant déterminé à chaque itération i à partir d'une i-ème courbe de dégradation associée au i-ème cyclage et en posant que le i-ème état de santé initial est égal au (i-1)-ème état de santé final à la fin du (i-1)-ème cyclage ;
le système comprenant en outre une unité de transmission configurée pour transmettre un signal représentatif de l'état de santé final de la batterie à un dispositif utilisateur.

Avantageusement, l'unité de réception est configurée pour recevoir en outre du système de gestion de batterie BMS un signal de début et un signal de fin de fonctionnement de la batterie selon un cyclage particulier correspondant à une courbe de dégradation spécifique au premier cyclage.

De plus, pour i = 2 à i = N, l'unité de réception 4 est configurée pour recevoir en outre du système de gestion de batterie BMS un signal de début puis un signal de fin de fonctionnement de la batterie selon un cyclage particulier correspondant à une courbe de dégradation spécifique au i-ème cyclage Cᵢ.

Avantageusement, l'unité de calcul est configurée avec i = 2 à i = N pour :
- déterminer une i-ème énergie initiale au début du i-ème cyclage à partir d'un i-ème état de santé initial et d'une i-ème courbe de dégradation, le i-ème état de santé initial étant égal au (i-1)-ème état de santé final à la fin du (i-1)-ème cyclage,
- déterminer un i-ème état de santé final à la fin du i-ème cyclage à partir de la i-ème courbe de dégradation associée au i-ème cyclage et d'une somme de la i-ème énergie initiale et d'une i-ème énergie déchargée pendant le i-ème cyclage,
- déterminer un état de santé de la batterie, l'état de santé de la batterie étant égale à la différence entre le i-ème état de santé initial et le i-ème état de santé final.

De plus, le premier cyclage présente un état de santé initial correspondant à un état de santé d'une batterie neuve.

Par ailleurs, l'unité de réception est en outre configurée pour :
- recevoir des premières données de fonctionnement caractéristiques du premier cyclage, la première courbe de dégradation étant choisie par l'unité de calcul en fonction des données de fonctionnement ;
- recevoir des i-èmes données de fonctionnement avec i = 2 à i = N, la i-ème courbe de dégradation étant choisie par l'unité de calcul en fonction des i-èmes données de fonctionnement.

L'invention concerne également un véhicule automobile électrique ou hybride comprenant au moins une batterie susceptible d'être soumise à N cyclages successifs, N étant au moins égal à deux,
comportant un système de détermination d'un état de santé final d'une batterie, tel que spécifié ci-dessus.

### Brève description des figures

Les figures annexées feront bien comprendre comment l'invention peut être réalisée. Sur ces figures, des références identiques désignent des éléments semblables.
La figure 1 représente schématiquement le système de détermination.
La figure 2 représente schématiquement le procédé de détermination.
La figure 3 représente schématiquement la i-ème étape de détermination du procédé de détermination.
La figure 4 représente un graphe de courbes de dégradation indiquant l'état de santé d'une batterie en fonction de l'énergie déchargée par la batterie.
La figure 5 représente un véhicule automobile électrique ou hybride comprenant le système de détermination.

### Description détaillée

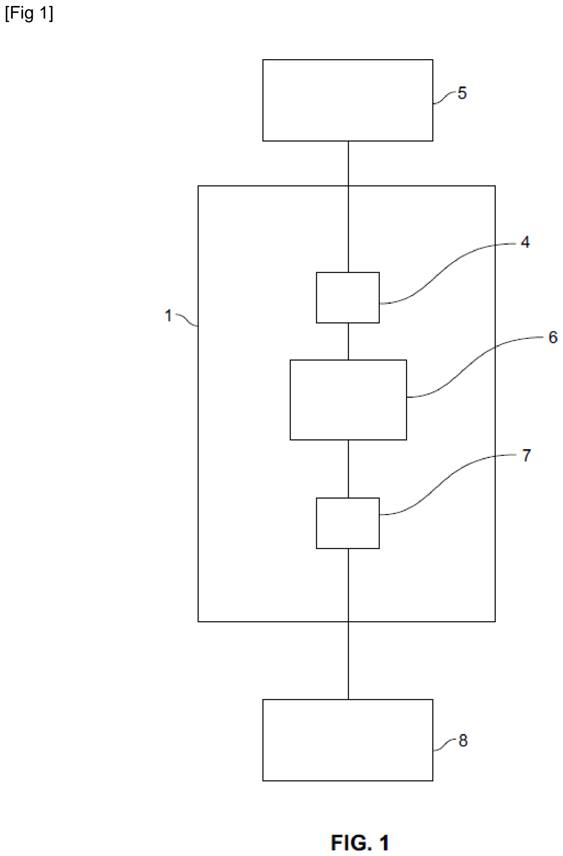

Le système de détermination 1 d'un état de santé final SoH_{1N} d'une batterie 2 d'un véhicule automobile 3 électrique ou hybride susceptible d'être soumise à une pluralité de N cyclages successifs est représenté schématiquement sur la figure 1. Il est appelé « système de détermination 1 » dans la suite de la description.

Le paramètre N, qui correspond au nombre de cyclages successifs auxquels la batterie 2 est soumise, est un nombre entier naturel au moins égal à deux.

Chaque cyclage est associé à une courbe de dégradation C₁, ..., C_{N} indiquant l'état de santé de la batterie 2 en fonction d'une énergie déchargée par la batterie 2.

Deux cyclages consécutifs présentent des profils de dégradation distincts l'un de l'autre. En d'autres termes, deux courbes de dégradation consécutives Cᵢ et Cᵢ₊₁ sont distinctes l'une de l'autre. Cependant, il est possible que certaines courbes de dégradation de deux cyclages non consécutifs soient identiques, par exemple si le type d'utilisation du véhicule redevient le même.

Une courbe de dégradation C₁, ..., C_{N} peut dépendre, entre autres, du type d'utilisation de la batterie pendant le cyclage auquel elle est associée, des conditions d'utilisation telles que la température ambiante et/ou de l'état de charge (SoC pour « State of Charge » en anglais) de la batterie 2. Le SoC correspond à une mesure relative de la quantité d'énergie stockée dans une batterie. Elle est définie comme étant le rapport entre la charge de la cellule à un certain moment et sa capacité totale.

Une courbe de dégradation peut aussi être liée au type d'utilisation du véhicule. Notamment, de manière non limitative, on peut distinguer :
- une courbe de dégradation correspondant au roulage du véhicule (vitesse strictement supérieure à 0 km/h) ;
- une courbe de dégradation liée à une charge lente du véhicule ;
- une courbe de dégradation liée à une charge rapide du véhicule ;
- une courbe de dégradation liée à l'utilisation du véhicule selon un profil dit V2G (« Vehicle-to-Grid ») qui consiste à charger un réseau électrique extérieur par la batterie du véhicule ;
- etc.

Le système de détermination comprend au moins une unité de réception 4, une unité de calcul 6 et une unité de transmission 7.

L'unité de calcul 6 peut correspondre à un module logiciel ou électronique d'un ordinateur de bord embarqué dans le véhicule automobile 3. L'unité de calcul 6 peut aussi correspondre à un module logiciel ou électronique du système de gestion de batterie BMS (pour « Batterie management system » en anglais) du véhicule automobile 3. Les courbes de dégradation C₁, ..., C_{N} peuvent être stockées dans un module de stockage (non représenté) du système de gestion de batterie. Le paramètre N peut être limité par la capacité de mémorisation du système de gestion de batterie.

Les courbes de dégradation C₁, ..., C_{N} peuvent être stockées dans un module de stockage (non représenté). Le paramètre N peut être limité par la capacité de mémorisation du module de stockage contenant les courbes de dégradations C₁, ..., C_{N}.

L'unité de réception 4 est configurée pour recevoir d'un compteur d'énergie 5 un signal représentatif d'une première énergie déchargée X₁ pendant le premier cyclage. Le compteur d'énergie 5 d'une batterie mesure la quantité d'énergie chargée ou déchargée par la batterie 2. Par exemple, cette quantité d'énergie est exprimée en kWh.

L'unité de réception 4 peut être configurée pour recevoir en outre du système de gestion de batterie BMS un signal de début et un signal de fin de fonctionnement de la batterie selon un cyclage particulier correspondant à une courbe de dégradation spécifique au premier cyclage C₁.

Le premier cyclage peut présenter un état de santé initial SoH₁ₐ correspondant à un état de santé d'une batterie 2 neuve.

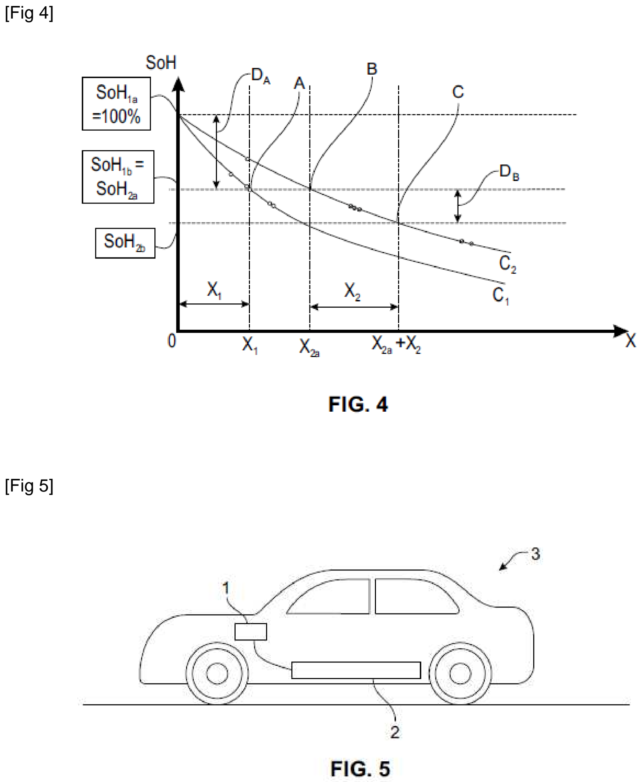

La figure 4 illustre la mise en œuvre du système avec N = 2. Elle représente deux courbes de dégradation C₁ et C₂ dans un repère comportant l'état de santé de la batterie SoH (en pourcentage) en fonction de la quantité d'énergie chargée ou déchargée X (en kWh par exemple).

L'unité de calcul 6 est configurée pour déterminer un premier état de santé final SoH_{1b} à la fin d'un premier cyclage à partir d'une première courbe de dégradation C₁ associée au premier cyclage et de la première énergie déchargée X₁ pendant le premier cyclage. Sur la figure 4, le premier état de santé final SoH_{1b} est déterminé au point A (voir figure 4) de la courbe de dégradation C₁. On observe ainsi une dégradation D_{A} de la SoH de la batterie 2.

Pour i = 2 à i = N, l'unité de réception 4 est en outre configurée pour recevoir du compteur d'énergie 5 une i-ème énergie déchargée Xᵢ pendant le i-ème cyclage.

De plus, pour i = 2 à i = N, l'unité de réception 4 peut être configurée pour recevoir en outre du système de gestion de batterie BMS un signal de début puis un signal de fin de fonctionnement de la batterie selon un cyclage particulier correspondant à une courbe de dégradation spécifique au i-ème cyclage Ci.

Pour i = 2 à i = N, l'unité de calcul 6 est en outre configurée pour déterminer l'état de santé final SoH_{1N}.

Un i-ème état de santé final SoH_{ib} à la fin d'un i-ème cyclage est déterminé à chaque itération i à partir d'une i-ème courbe de dégradation Cᵢ associée au i-ème cyclage. On pose en outre que le i-ème état de santé initial SoHᵢₐ est égal au (i-1)-ème état de santé final SoH_{(i-1)b} à la fin du (i-1)-ème cyclage.

Le système de détermination 1 comprend en outre une unité de transmission 7 configurée pour transmettre un signal représentatif de l'état de santé final SoH_{1N} de la batterie 2 à un dispositif utilisateur 8.

Le dispositif utilisateur 8 peut comprendre une unité d'affichage configurée pour afficher le SoH de la batterie 2.

Avantageusement, avec i = 2 à i = N, l'unité de calcul 6 peut être configurée pour :
- déterminer une i-ème énergie initiale Xᵢₐ au début du i-ème cyclage à partir d'un i-ème état de santé initial SoHᵢₐ et d'une i-ème courbe de dégradation Cᵢ, le i-ème état de santé initial SoHᵢₐ étant égal au (i-1)-ème état de santé final SoH_{(i-1)b} à la fin du (i-1)-ème cyclage,
- déterminer un i-ème état de santé final SoH_{ib} à la fin du i-ème cyclage à partir de la i-ème courbe de dégradation Cᵢ associée au i-ème cyclage et d'une somme de la i-ème énergie initiale Xᵢₐ et d'une i-ème énergie déchargée Xᵢ pendant le i-ème cyclage,
- déterminer un état de santé de la batterie, l'état de santé de la batterie étant égale à la différence entre le i-ème état de santé initial SoHᵢₐ et le i-ème état de santé final SoH_{ib}.

Sur la figure 4, la deuxième énergie initiale X₂ₐ au début du deuxième cyclage est déterminée à partir d'un deuxième état de santé initial SoH₂ₐ et d'une deuxième courbe de dégradation C₂ (point B sur la figure 4). Le deuxième état de santé initial SoH₂ₐ est égal au premier état de santé final SoH_{1b} à la fin du premier cyclage. Le deuxième état de santé final SoH_{2b} à la fin du deuxième cyclage est déterminé à partir de la deuxième courbe de dégradation C₂ associée au deuxième cyclage et d'une somme de la deuxième énergie initiale X₂ₐ et d'une deuxième énergie déchargée X₂ pendant le deuxième cyclage (point C de la figure 4). On observe ainsi une dégradation D_{B} du SoH de la batterie 2 qui s'additionne à la dégradation D_{A} du SoH de la batterie 2.

L'état de santé de la batterie étant égale à la différence entre le deuxième état de santé initial SoH₂ₐ et le deuxième état de santé final SoH_{2b}.

Par ailleurs, l'unité de réception 4 peut être en outre configurée pour recevoir des premières données de fonctionnement caractéristiques du premier cyclage. La première courbe de dégradation C₁ est alors choisie par l'unité de calcul 6 en fonction des données de fonctionnement.

De même, pour i = 2 à i = N, l'unité de réception 4 peut être configurée pour recevoir des i-èmes données de fonctionnement avec i = 2 à i = N. La i-ème courbe de dégradation Cᵢ est alors choisie par l'unité de calcul 6 en fonction des i-èmes données de fonctionnement.

De façon non limitative, les données de fonctionnement peuvent comprendre au moins un des paramètres suivants : la température de l'environnement dans lequel fonctionne la batterie 2, le SoC de la batterie 2, le type de fonctionnement de la batterie 2.

Les courbes de dégradation C₁, ..., C_{N} peuvent comprendre des coefficients dépendants de ces données de fonctionnement.

Les courbes de dégradation peuvent aussi correspondre à la reconnaissance d'un type de fonctionnement spécifique à la batterie (roulage véhicule, charge rapide, charge lente, utilisation de type V2G, etc.).

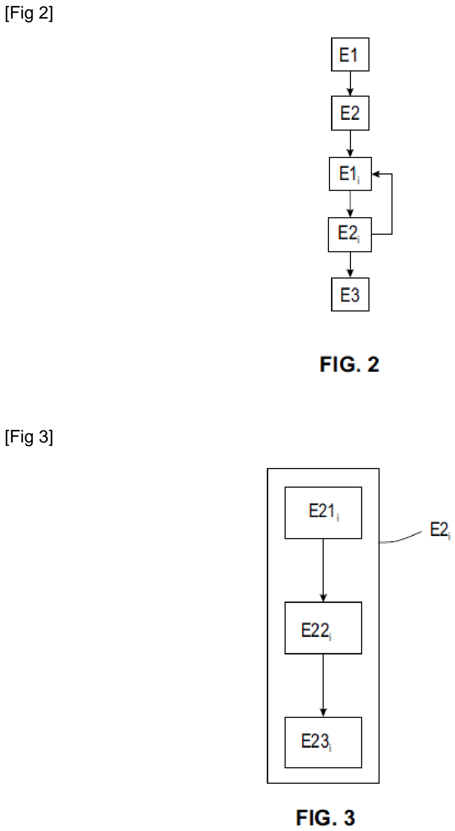

L'invention concerne également un procédé de détermination d'un état de santé final SoH_{1N} d'une batterie 2 d'un véhicule automobile 3 électrique ou hybride soumis à N cyclages successifs (figure 2).

Le procédé de détermination comprend les étapes suivantes :
- une première étape de réception E1, mise en œuvre par l'unité de réception 4, pour recevoir d'un compteur d'énergie 5 un signal représentatif d'une première énergie déchargée X₁ pendant le premier cyclage ;
- une première étape de détermination E2, mise en œuvre par l'unité de calcul 6, pour déterminer un premier état de santé final SoH_{1b} à la fin d'un premier cyclage à partir d'une première courbe de dégradation C₁ associée au premier cyclage et de la première énergie déchargée X₁ pendant le premier cyclage ;
- la suite d'étapes suivantes répétée de i = 2 à i = N :
   ∘ une i-ème étape de réception E1ᵢ, mise en œuvre par l'unité de réception 4, pour recevoir du compteur d'énergie 5 un signal représentatif d'une i-ème énergie déchargée Xᵢ pendant le i-ème cyclage,
   ∘ une i-ème étape de détermination E2ᵢ, mise en œuvre par l'unité de calcul 6, pour déterminer l'état de santé final SoH_{1N}, un i-ème état de santé final SoH_{ib} à la fin du i-ème cyclage étant déterminé à partir d'une i-ème courbe de dégradation Cᵢ associée au i-ème cyclage et en posant que le i-ème état de santé initial SoHᵢₐ est égal au (i-1)-ème état de santé final SoH_{(i-1)b} à la fin du (i-1)-ème cyclage.

La suite d'étapes est suivie d'une étape de transmission E3, mise en œuvre par l'unité de transmission 7, pour transmettre un signal représentatif de l'état de santé final SoH_{1N} de la batterie 2 à un dispositif utilisateur 8.

De plus, la première étape de réception E1 peut être mise en œuvre par l'unité de réception 4 pour recevoir en outre du système de gestion de batterie BMS un signal de début et un signal de fin de fonctionnement de la batterie selon un cyclage particulier correspondant à une courbe de dégradation spécifique au premier cyclage C₁.

De même, la i-ème étape de réception E1ᵢ peut être mise en œuvre par l'unité de réception 4 pour recevoir en outre du système de gestion de batterie BMS un signal de début puis un signal de fin de fonctionnement de la batterie selon un cyclage particulier correspondant à une courbe de dégradation spécifique au i-ème cyclage Cᵢ.

Avantageusement, la i-ème étape de détermination E2ᵢ (figure 3) comprend :
- une sous-étape de détermination E21ᵢ d'une i-ème énergie initiale Xᵢₐ au début du i-ème cyclage à partir d'un i-ème état de santé initial SoHᵢₐ et d'une i-ème courbe de dégradation Cᵢ, le i-ème état de santé initial SoHᵢₐ étant égal au (i-1)-ème état de santé final SoH_{(i-1)b} à la fin du (i-1)-ème cyclage,
- une sous-étape de détermination E22ᵢ d'un i-ème état de santé final SoH_{ib} à la fin du i-ème cyclage à partir de la i-ème courbe de dégradation Cᵢ associée au i-ème cyclage et d'une somme de la i-ème énergie initiale Xᵢₐ et d'une i-ème énergie déchargée Xᵢ pendant le i-ème cyclage,
- une sous-étape de détermination E23ᵢ d'un état de santé de la batterie, l'état de santé de la batterie étant égale à la différence entre le i-ème état de santé initial SoHᵢₐ et le i-ème état de santé final SoH_{ib}.

Par ailleurs, la première étape de réception E1 peut être mise en œuvre par l'unité de réception 4 en outre pour recevoir les premières données de fonctionnement caractéristiques du premier cyclage, la première courbe de dégradation C₁ étant choisie par l'unité de calcul 6 en fonction des données de fonctionnement.

De même, la i-ème étape de réception E1ᵢ peut être mise en œuvre par l'unité de réception 4 en outre pour recevoir des i-èmes données de fonctionnement, la i-ème courbe de dégradation Cᵢ étant choisie par l'unité de calcul 6 en fonction des i-èmes données de fonctionnement.

## Revendications

1. Procédé de détermination d'un état de santé final (SoH_{1N}) d'une batterie (2) d'un véhicule automobile (3) électrique ou hybride susceptible d'être soumise à N cyclages successifs, N étant au moins égal à deux, chaque cyclage étant associé à une courbe de dégradation (C₁, ..., C_{N}) indiquant l'état de santé de la batterie (2) en fonction d'une énergie déchargée par la batterie (2), les courbes de dégradation de deux cyclages consécutifs étant distinctes l'une de l'autre,
**caractérisé en ce qu'**il comprend les étapes suivantes :
- une première étape de réception (E1), mise en œuvre par une unité de réception (4), pour recevoir d'un compteur d'énergie (5) un signal représentatif d'une première énergie déchargée (X₁) pendant le premier cyclage ;
- une première étape de détermination (E2), mise en œuvre par une unité de calcul (6), pour déterminer un premier état de santé final (SoH_{1b}) à la fin d'un premier cyclage à partir d'une première courbe de dégradation (C₁) associée au premier cyclage et de la première énergie déchargée (X₁) pendant le premier cyclage ;
- la suite d'étapes suivantes répétée de i = 2 à i = N :
∘ une i-ème étape de réception (E1ᵢ), mise en œuvre par l'unité de réception (4), pour recevoir du compteur d'énergie (5) un signal représentatif d'une i-ème énergie déchargée (Xᵢ) pendant le i-ème cyclage,
∘ une i-ème étape de détermination (E2ᵢ), mise en œuvre par l'unité de calcul (6), pour déterminer l'état de santé final (SoH_{1N}), un i-ème état de santé final (SoH_{ib}) à la fin du i-ème cyclage étant déterminé à partir d'une i-ème courbe de dégradation (Ci) associée au i-ème cyclage et en posant que le i-ème état de santé initial (SoHᵢₐ) est égal au (i-1)-ème état de santé final (SoH_{(i-1)b}) à la fin du (i-1)-ème cyclage ;
- une étape de transmission (E3), mise en œuvre par une unité de transmission (7), pour transmettre un signal représentatif de l'état de santé final (SoH_{1N}) de la batterie (2) à un dispositif utilisateur (8).

2. Procédé selon la revendication 1,
**caractérisé en ce que** la i-ème étape de détermination (E2ᵢ) comprend :
- une sous-étape de détermination (E21ᵢ) d'une i-ème énergie initiale (Xᵢₐ) au début du i-ème cyclage à partir d'un i-ème état de santé initial (SoHᵢₐ) et d'une i-ème courbe de dégradation (Ci), le i-ème état de santé initial (SoHᵢₐ) étant égal au (i-1)-ème état de santé final (SoH_{(i-1)b}) à la fin du (i-1)-ème cyclage,
- une sous-étape de détermination (E22ᵢ) d'un i-ème état de santé final (SoH_{ib}) à la fin du i-ème cyclage à partir de la i-ème courbe de dégradation (Ci) associée au i-ème cyclage et d'une somme de la i-ème énergie initiale (Xᵢₐ) et d'une i-ème énergie déchargée (Xᵢ) pendant le i-ème cyclage,
- une sous-étape de détermination (E23ᵢ) d'un état de santé de la batterie, l'état de santé de la batterie étant égale à la différence entre le i-ème état de santé initial (SoHᵢₐ) et le i-ème état de santé final (SoH_{ib}).

3. Procédé selon l'une des revendications 1 et 2,
**caractérisé en ce que** le premier cyclage présente un état de santé initial (SoH₁ₐ) correspondant à un état de santé d'une batterie neuve.

4. Procédé selon l'une des revendications 1 à 3,
**caractérisé en ce que** la première étape de réception (E1) est mise en œuvre par l'unité de réception (4) en outre pour recevoir des premières données de fonctionnement caractéristiques du premier cyclage, la première courbe de dégradation (C₁) étant choisie par l'unité de calcul (6) en fonction des données de fonctionnement ;
la i-ème étape de réception (E1ᵢ) étant mise en œuvre par l'unité de réception (4) en outre pour recevoir des i-èmes données de fonctionnement, la i-ème courbe de dégradation (Ci) étant choisie par l'unité de calcul (6) en fonction des i-èmes données de fonctionnement.

5. Système de détermination d'un état de santé final (SoH_{1N}) d'une batterie (2) d'un véhicule automobile (3) électrique ou hybride susceptible d'être soumise à N cyclages successifs, N étant au moins égal à deux, chaque cyclage étant associé à une courbe de dégradation (C₁, ..., C_{N}) indiquant l'état de santé de la batterie (2) en fonction d'une énergie déchargée par la batterie (2), les courbes de dégradation de deux cyclages consécutifs étant distinctes l'une de l'autre,
**caractérisé en ce qu'**il comprend :
- une unité de réception (4) configurée pour recevoir d'un compteur d'énergie (5) un signal représentatif d'une première énergie déchargée (X₁) pendant le premier cyclage,
- une unité de calcul (6) configurée pour déterminer un premier état de santé final (SoH_{1b}) à la fin d'un premier cyclage à partir d'une première courbe de dégradation (C₁) associée au premier cyclage et de la première énergie déchargée (X₁) pendant le premier cyclage ;
pour i = 2 à i = N :
- l'unité de réception (4) étant configurée pour recevoir du compteur d'énergie (5) un signal représentatif d'une i-ème énergie déchargée (Xᵢ) pendant le i-ème cyclage,
- l'unité de calcul (6) étant configurée pour déterminer l'état de santé final (SoH_{1N}), un i-ème état de santé final (SoH_{ib}) à la fin du i-ème cyclage étant déterminé à chaque itération i à partir d'une i-ème courbe de dégradation (Ci) associée au i-ème cyclage et en posant que le i-ème état de santé initial (SoHᵢₐ) est égal au (i-1)-ème état de santé final (SoH_{(i-1)b}) à la fin du (i-1)-ème cyclage ;
le système comprenant en outre une unité de transmission (7) configurée pour transmettre un signal représentatif de l'état de santé final (SoH_{1N}) de la batterie (2) à un dispositif utilisateur (8).

6. Système selon la revendication 5,
**caractérisé en ce que** l'unité de calcul (6) est configurée avec i = 2 à i = N pour :
- déterminer une i-ème énergie initiale (Xᵢₐ) au début du i-ème cyclage à partir d'un i-ème état de santé initial (SoHᵢₐ) et d'une i-ème courbe de dégradation (Ci), le i-ème état de santé initial (SoHᵢₐ) étant égal au (i-1)-ème état de santé final (SoH_{(i-1)b}) à la fin du (i-1)-ème cyclage,
- déterminer un i-ème état de santé final (SoH_{ib}) à la fin du i-ème cyclage à partir de la i-ème courbe de dégradation (Ci) associée au i-ème cyclage et d'une somme de la i-ème énergie initiale (Xᵢₐ) et d'une i-ème énergie déchargée (Xᵢ) pendant le i-ème cyclage,
- déterminer un état de santé de la batterie, l'état de santé de la batterie étant égale à la différence entre le i-ème état de santé initial (SoHᵢₐ) et le i-ème état de santé final (SoH_{ib}).

7. Système selon l'une des revendications 5 et 6,
**caractérisé en ce que** le premier cyclage présente un état de santé initial (SoH₁ₐ) correspondant à un état de santé d'une batterie neuve.

8. Système selon l'une des revendications 5 à 7,
**caractérisé en ce que** l'unité de réception (4) est en outre configurée pour :
- recevoir des premières données de fonctionnement caractéristiques du premier cyclage, la première courbe de dégradation (C₁) étant choisie par l'unité de calcul (6) en fonction des données de fonctionnement ;
- recevoir des i-èmes données de fonctionnement avec i = 2 à i = N, la i-ème courbe de dégradation (Ci) étant choisie par l'unité de calcul (6) en fonction des i-èmes données de fonctionnement.

9. Véhicule automobile électrique ou hybride comprenant au moins une batterie susceptible d'être soumise à N cyclages successifs, N étant au moins égal à deux, **caractérisé en ce qu'**il comporte un système de détermination (1) d'un état de santé final d'une batterie (2), tel que spécifié sous l'une quelconque des revendications 5 à 8.
